# EUROPEAN PATENT APPLICATION

(11) **EP 1 631 135 A2**
(43) Date of publication of application: **01.03.2006**
(21) Application number: 05017620.5
(22) Date of filing: 12.08.2005
(51) Int. Cl.: H05K 7/20

(54) **System and method for managing temperature in an interior-portion of a cabinet**

(30) Priority: 30.08.2004 US 606082 P; 19.11.2004 US 993623
(71) Applicant: Power-One AS, 3036 Drammen (NO)
(72) Inventor: Spangberg, Erik, 3038 Drammen (NO)
(74) Representative: Winter, Brandl, Fürniss, Hübner Röss, Kaiser, Polte Partnerschaft Patent- und Rechtsanwaltskanzlei

(57) **Abstract**

A system and method is provided for using a heat exchanger to manage the temperature of at least one electrical device in an interior-portion of a cabinet. Specifically, in accordance with one embodiment of the present invention, the cabinet includes at least a floor, a roof, and a plurality of walls connected (at least partially) therebetween. At least one wall of the cabinet is constructed using a plurality of layers (e.g., inner layer, outer layer, middle layer, etc.) and/or ribs, thereby defining at least two channels. In the first channel, an air-to-air heat exchanger is disposed. In the second channel, air (external or internal) is routed from the heat exchanger to at least one fan. The thermal-transfer properties of the heat exchanger and the fan allow the temperature in the interior-portion of the cabinet, and thus the temperature of the electrical device located therein, to be managed (e.g., heated, cooled, maintained, etc.). In another embodiment of the present invention, multiple walls are constructed using a plurality of layers and/or ribs, thereby defining more than one channel for routing air to/from the heat exchanger. In yet another embodiment, the roof is constructed using a plurality of layers and/or ribs, thereby defining at least one channel for routing air to/from the fans that are housed therein.

## Description

### CROSS-REFERENCE TO RELATED APPLICATION

This application claims the benefit pursuant to 35 U.S.C. § 119(e) of U.S. Provisional Patent Application No. 60/606082, filed August 30, 2004, which application is specifically incorporated herein, in its entirety, by reference.

### BACKGROUND OF THE INVENTION

### 1. Field of the Invention

The present invention relates to managing thermal energy in electrical devices, or more particularly, to a system and method of using a heat exchanger and a plurality of circulatory channels to manage temperature (e.g., cool, heat, maintain, etc.) in at least one electrical device mounted in an interior-portion of a cabinet.

### 2. Description of Related Art

Electronic circuits are becoming more and more common as today's technology advances. Also becoming more are more common are cabinets (e.g., indoor cabinets, outdoor cabinets, etc.) that are used to house electronic circuits. These cabinets further offer a degree of protection. For example, cabinets are used to protect individuals from high voltage electrical devices, protect electrical devices from environmental conditions (e.g., dust, rain, etc.), etc.

A drawback, however, of using a cabinet to house an electrical device is that it becomes more difficult to managing the thermal energy in the device. In other words, additional steps may need to be taken to cool and/or heat the device. This is because thermal conditions (e.g., a cool breeze, a heated room, etc.) that might normally be used to cool and/or heat an electrical device may not be sufficient if the device is mounted inside a cabinet. This becomes extremely important when the device is capable of generating a great deal of heat and/or is sensitive to changes in temperature.

The traditional method of managing heat in an electrical device mounted in an interior-portion of a cabinet is through the use of a heat exchanger (e.g., an air-to-air heat exchanger, etc.). Specifically, the heat exchanger is attached to a surface of the cabinet (e.g., a top surface, a side surface, an inner surface, an outer surface, etc.) so that air can pass therethrough. More particularly, internal air, which is heated (or cooled) by the electrical device, is routed through a first chamber in the heat exchanger and external air is routed through a second chamber in the heat exchanger. Due to the thermal properties of the heat exchanger, thermal energy is transferred between the two chambers even though the two chambers remain physically separate (i.e., the internal and external air are not allowed to mix). Thus, if the external air is cooler than the internal air, the internal air (and thus the temperature of the electrical device) is cooled. If, however, the external air is warmer than the internal air, the internal air (and thus the temperature of the electrical device) is heated.

One drawback of such a method lies in the manner in which the heat exchanger is mounted to the cabinet. For example, by mounting a heat exchanger on an outer surface of a cabinet (e.g., an outer side-wall, etc.), the cabinet becomes bulky and asymmetrical, thereby requiring more space (e.g., in a warehouse, etc.). Similarly, by mounting a heat exchanger on an inner surface of a cabinet (e.g., an inner side-wall, etc.), the available interior space is reduced, thereby limiting the amount of electrical devices that can be mounted therein.

Despite such a drawback, certain features of this method deter (or hinder) improvements in this field. For example, by mounting a heat exchanger to a surface of a cabinet, a pre-manufactured (or off-the-shelf) cabinet can be used to house an electrical device. This is because the heat exchanger only needs to be mounted to an existing (standard) surface of a cabinet. Another feature of this method is that certain portions of air can be provided to the heat exchanger without having to pass through the cabinet wall, which might require customization. For example, if the heat exchanger is mounted to an outer surface of the cabinet, external air can be provided to (and expelled from) the heat exchanger without ever having to be ducted through a cabinet wall. As another example, if the heat exchanger is mounted to an inner surface of the cabinet, internal air can be provided to (and expelled from) the heat exchanger without ever having to be ducted through a cabinet wall.

While such features make it easier to utilize an off-the-shelf cabinet with an off-the-shelf heat exchanger, the resulting product still suffers from the aforementioned drawback (e.g., cabinets having substantially larger exteriors and/or substantially smaller interiors). Thus, it would be advantageous to have a system and method of managing temperature in an interior-portion of a cabinet that does not substantial increase the overall size of a cabinet or substantially decrease its available interior space.

### SUMMARY OF THE INVENTION

The present invention provides a system and method of using a heat exchanger (e.g., an air-to-air heat exchanger, etc.) to manage temperature (e.g., cool, heat, maintain, etc.) in at least one electrical device mounted in an interior-portion of a cabinet (e.g., indoor cabinet, outdoor cabinet, etc.). Embodiments of the present invention operate in accordance with a cabinet that includes at least a floor, a roof, and a plurality of walls connected (at least partially) therebetween.

In a preferred embodiment of the present invention, a cabinet includes a floor, a roof, a plurality of walls located therebetween, and an electrical device located in a substantially sealed interior-portion of the cabinet. A first internal-circulation system is used to circulate internal air, which is heated by the electrical device, through a heat exchanging device. A second internal-circulation system is then used to circulate external air, which enters the cabinet via vents, through the heat exchanging device and out of the cabinet. Due to the thermal-transfer properties of the heat exchanging device, the temperature of the internal air can be managed.

In one embodiment of the present invention, a first wall of the cabinet is constructed using a plurality of layers (e.g., an inner layer, an outer layer, a middle layer, etc.) and/or ribs, thereby defining at least one channel (or passageway) inside the first wall structure. In a preferred embodiment of the present invention, the channel is used (at least in part) to house an air-to-air heat exchanger.

In another embodiment of the present invention, a second wall of the cabinet is constructed using a plurality of layers and/or ribs, thereby defining at least one channel (or passageway) inside the second wall structure. In a preferred embodiment of the present invention, two channels are defined in the second wall. The first channel allows external air to pass (e.g., be ducted) from a first portion of the air-to-air heat exchanger to a first fan, and the second channel allows external air to pass from a second portion of the air-to-air heat exchanger to a second fan. The first and second fans, which are housed in the roof, are then used to force the external air out of the cabinet.

In another embodiment of the present invention, the first wall of the cabinet further includes two inner channels. The first and second channels allow internal air to pass from the first and second portions of the air-to-air heat exchanger to a third and fourth fan, respectively. The third and fourth fans, which are housed in the roof, are then used to force the internal air back into the interior-portion of the cabinet. The internal air is then forced over (or through) the electronic device using a plurality of internally-located fans. The internal air (as heated by the electronic device) is then pulled (via the vacuum created by the third and fourth fans) into the air-to-air heat exchanger, where the first internal-circulatory process is repeated.

In another embodiment of the present invention, the roof is constructed using a cover structure (e.g., for coving the fans, etc.) and a plurality of ribs and/or layers, thereby defining a plurality of channels (or passageways). These channels are used to pass air (internal and external) from the channels in the first and second walls to the first, second, third and fourth fans.

A more complete understanding of the system and method of using a heat exchanger and a plurality of circulatory channels to manage the temperature in an interior-portion of a cabinet will be afforded to those skilled in the art, as well as a realization of additional advantages and objects thereof, by a consideration of the following detailed description of the preferred embodiment. Reference will be made to the appended sheets of drawings which will first be described briefly.

### BRIEF DESCRIPTION OF THE DRAWINGS

Figure 1 depicts a cabinet that is adapted to manage the temperature in at least one electrical device, the electrical device being located in an interior-portion of the cabinet, in accordance with one embodiment of the present invention.
Figure 2 provides a transparent view of two walls (i.e., a first wall and a second wall) and a roof of the cabinet, as depicted in Figure 1, and illustrates one manner in which external air can be routed through the cabinet.
Figure 3 provides another transparent view of the first wall and the roof of the cabinet, as depicted in Figure 1, and illustrates one manner in which internal air can be routed through the cabinet.
Figure 4 depicts an electrical device that is mounted in the cabinet, as depicted in Figure 1, and illustrates one manner in which internal air can be routed through the electrical device.
Figure 5 provides a cutaway view of the first wall, the second wall and the roof, as depicted in Figures 2 and 3.

### DETAILED DESCRIPTION OF THE PREFERRED EMBODIMENT

The present invention provides a system and method of using a heat exchanger (e.g., an air-to-air heat exchanger, etc.) to manage temperature (e.g., cool, heat, maintain, etc.) in at least one electrical device mounted in an interior-portion of a cabinet (e.g., indoor cabinet, outdoor cabinet, etc.). Embodiments of the present invention operate in accordance with a cabinet that includes at least a floor, a roof, and a plurality of walls connected (at least partially) therebetween. In the description that follows, like element numerals are used to describe like elements illustrated in one or more figures.

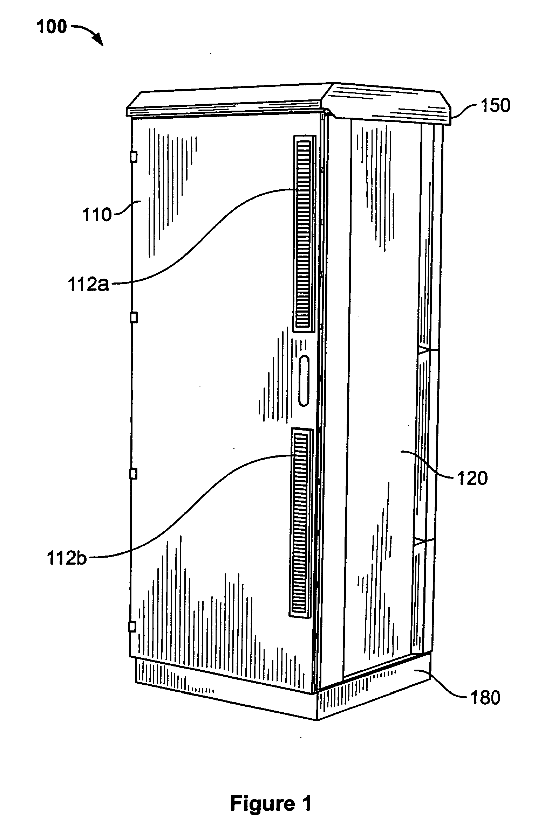

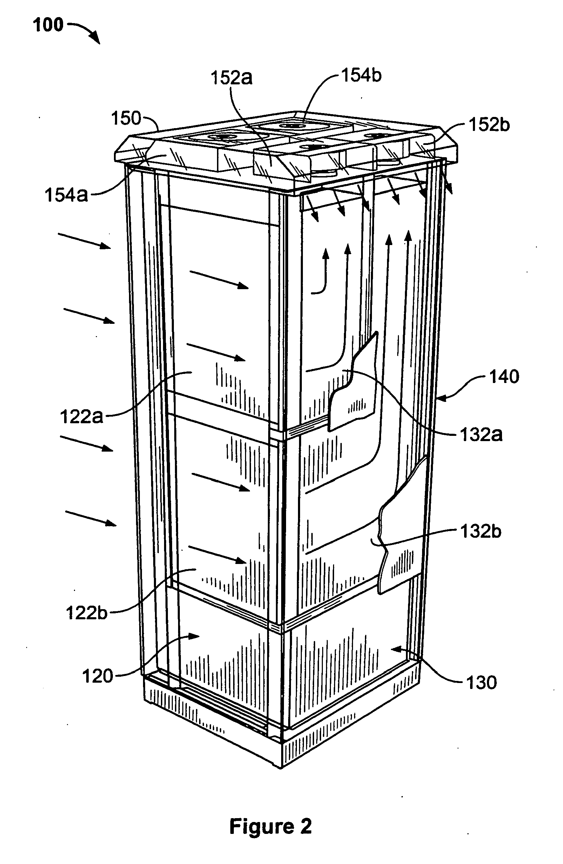

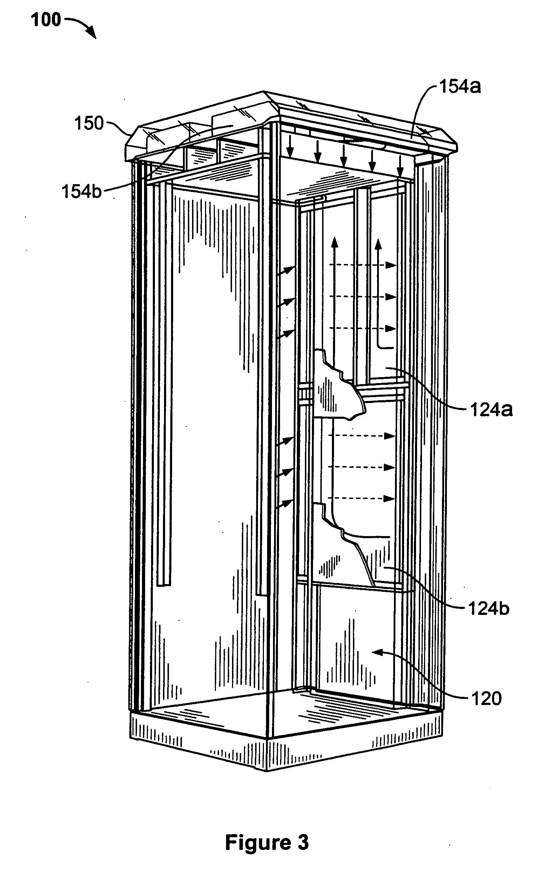

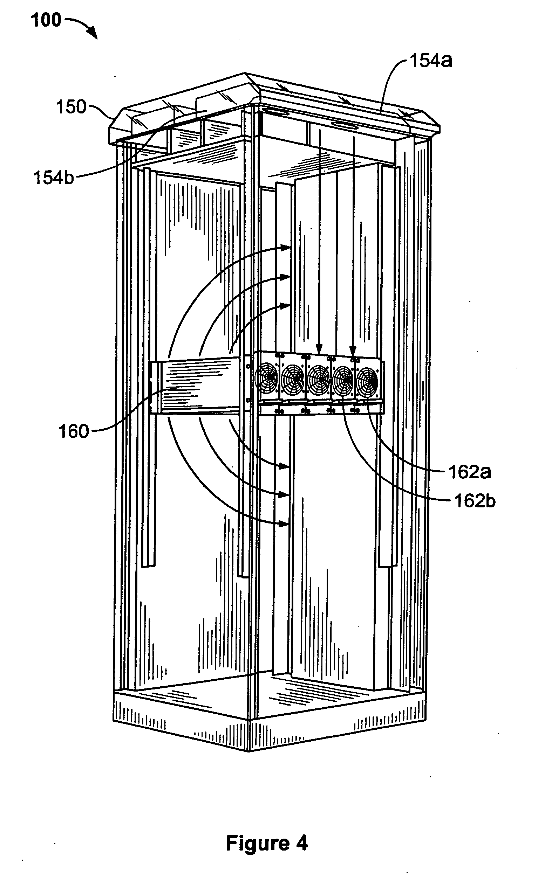

Figure 1 depicts a cabinet 100 that operates in accordance with one embodiment of the present invention. In this embodiment, the cabinet 100 includes a bottom 180, a top 150, a plurality of walls (e.g., 110, 120, etc.) located therebetween, and an electrical device located in a substantially sealed interior-portion of the cabinet (not shown). A first internal-circulation system (see Figures 3, 4) is used to circulate internal air, which is heated by the electrical device, through a heat exchanging device (not shown). A second internal-circulation system (see Figure 2) is then used to circulate external air, which enters the cabinet 100 via vents 112a, 112b, through the heat exchanging device and out of the cabinet 100. Due to the thermal-transfer properties of the heat exchanging device, the temperature of the internal air can be managed. For example, the internal air can be cooled by circulating cooler external air through the heat exchanging device, the internal air can be heated by circulating hotter external air through the heat exchanging device, the internal air can be substantially maintained by not circulating external air through the heat exchanging device, etc.

It should be appreciated that the present invention is not limited to any particular type or number of heat exchangers, and includes all gas and/or fluid heat exchangers generally known to those skilled in the art. For example, a cabinet that includes at least one heat exchanger adapted to circulate internal and external air is considered within the spirit and scope of the present invention. As another example, a cabinet that includes at least one heat exchanger adapted to circulate internal air and an external fluid (e.g., coolant, etc.) is considered within the spirit and scope of the present invention. It should further be appreciated that the present invention is not limited to any particular type or number of intake devices, and that the vents depicted in Figure 1 are merely provided to illustrate one embodiment of the present invention.

One embodiment of the second internal-circulation system is shown in Figure 2. In this embodiment, a first wall 120 of the cabinet 100 is constructed using a plurality of layers (e.g., an inner layer, an outer layer, a middle layer, etc.) and/or ribs (shown in transparencies), thereby defining at least one channel (or passageway) inside the first wall structure 120. In a preferred embodiment of the present invention, the channel is used (at least in part) to house an air-to-air heat exchanger (e.g., 122a, 122b) (or a first and second heat exchanger), thereby disposing the heat exchanger 122a, 122b within the first wall structure 120 of the cabinet 100.

Similarly, a second wall 130 of the cabinet 100 is constructed using a plurality of layers and/or ribs (shown in transparencies), thereby defining at least one channel (or passageway) inside the second wall structure 130. In a preferred embodiment of the present invention, two channels (e.g., 132a, 132b) are defined in the second wall 130. In this embodiment, the first channel 132a allows external air to pass (e.g., be ducted) from the first portion of the air-to-air heat exchanger 122a to a first fan 152a, and the second channel 132b allows external air to pass from the second portion of the air-to-air heat exchanger 122b to a second fan 152b. The first and second fans (e.g., 152a, 152b), which are housed in the roof 150, are then used to force the external air out of the cabinet 100.

It should be appreciated that the elements illustrated in Figure 2 are not to be considered limitations of the present invention, but are merely provided to illustrate one embodiment of the present invention. Thus, for example, a cabinet that includes additional, fewer or different elements (e.g., a roof comprising fewer fans, a floor comprising channels, a wall comprising more layers, fewer ribs, more channels, etc.) is within the spirit and scope of the present invention.

One embodiment of the first internal-circulation system is shown in Figure 3. In this embodiment, the first wall 120 of the cabinet 100 further includes two inner channels (e.g., 124a, 124b). The first and second inner channels (e.g., 124a, 124b) allow internal air to pass from the first and second portions of the air-to-air heat exchanger (e.g., 122a, 122b) to third and fourth fans (e.g., 154a, 154b), respectively.

As shown in Figure 4, the third and fourth fans 154a, 154b, which are located in the roof 150, are then used to force the internal air back into the interior-portion of the cabinet 100. The internal air is then forced over (or through) the electronic device 160 using a plurality of fans (e.g., 162a, 162b, etc.). The internal air (as heated by the electronic device 160) is then pulled (e.g., via the vacuum created by the third and fourth fans 154a, 154b) into the air-to-air heat exchanger (e.g., 122a, 122b), where the first internal-circulatory process is repeated. It should be appreciated that while the present invention is not limited to positioning fans (i) in the circulatory routes (e.g., the first and second internal-circulatory routes) and (ii) after the heat exchanger, by doing so several advantages are achieved. For example, by placing the fans as illustrated, air is pulled through the circulatory routes rather than being pushed. This results in less turbulence, and therefore a smaller pressure drop, in the heat exchanger, for example. Another advantage by placing the fans for the internal-circulation system after the heat exchangers is that the fans will experience cooler air, and therefore have a longer life.

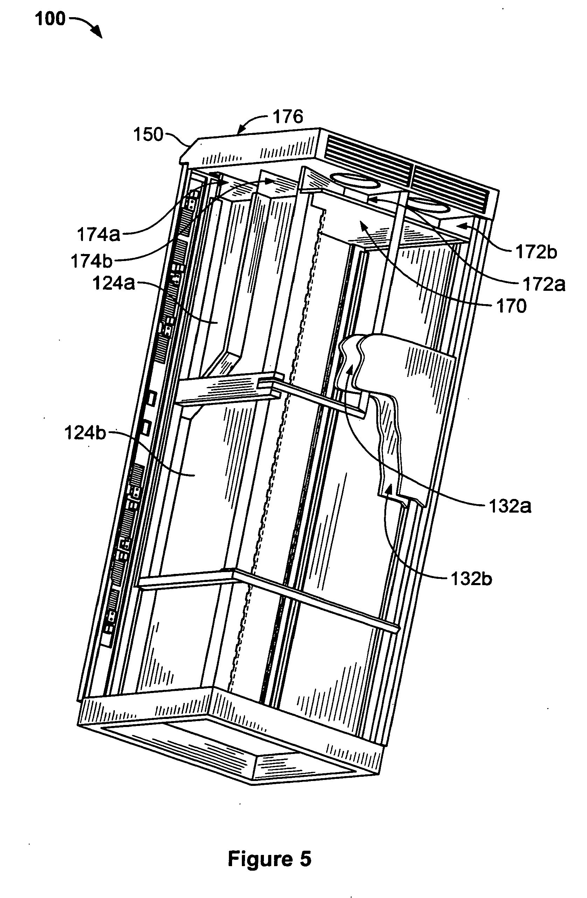

Another embodiment of the present invention is illustrated in Figure 5. In this embodiment, the roof 150 is constructed using a cover structure 176 and a plurality of ribs and layers (e.g., 170, etc.), thereby defining a plurality of channels (or passageways) (e.g., 172a, 172b, 174a, 174b). These channels are used to pass air (internal and external) from the channels in the first and second walls (e.g., 124a, 124b, 132a, 132b) to the first, second, third and fourth fans. For example, channel 172a can be used to pass external air from channel 132a to fan 152a. Similarly, channel 174b can be used to pass internal air from channel 124b to fan 154b. It should be appreciated that the channels illustrated in Figures 2-5 are not intended to limited the present invention, and are merely presented to illustrate certain embodiments of the present invention. Thus, for example, a cabinet having a floor, a roof, a plurality walls, and at least one channel located therein (e.g., in a particular wall, in the floor, etc.) is within the spirit and scope of the present invention.

Having thus described embodiments of a system and method of using an air-to-air heat exchanger and a plurality of circulatory channels to manage the temperature in an interior-portion of a cabinet, it should be apparent to those skilled in the art that certain advantages of the system have been achieved. It should also be appreciated that various modifications, adaptations, and alternative embodiments thereof may be made within the scope and spirit of the present invention. For example, the second internal-circulation system could be used to circulate a contained substance (e.g., cooled fluid, heated gas, etc.) through the heat exchanging device. The invention is further defined by the following claims.

## Claims

1. A cabinet for housing at least one electrical device, comprising:
a floor;
a first wall connected to said floor, said first wall comprising:
an inner and outer wall structure defining, at least partially, at least one channel located therebetween; and
an air-to-air heat exchanger mounted in at least a portion of said at least one channel in said first wall;
a second wall connected to said floor, said second wall comprising an inner and outer wall structure defining, at least partially, at least one channel located therebetween, wherein said at least one channel is connected to at least a portion of said air-to-air heat exchanger and adapted to transport, at least indirectly, external air between said air-to-air heat exchanger and a location outside of said cabinet; and
a roof connected to at least said first and second walls, said roof comprising at least one fan for circulating external air through at least said air-to-air heat exchanger and said at least one channel in said second wall.

2. The cabinet of Claim 1, wherein said inner structure of said first wall and said air-to-air heat exchanger further define, at least partially, at least one other channel, wherein said at least one other channel is adapted to transport, at least indirectly, internal air between said air-to-air heat exchanger and at least one other fan.

3. The cabinet of Claim 2, wherein said roof further comprises an outer roof structure and an inner roof structure defining, at least partially, at least one channel located therebetween, wherein said at least one channel in said roof is connected, at least indirectly, to (i) at least one of said at least one fan and said at least one other fan and (ii) at least one of said at least one channel in said second wall and said at least one other channel in said first wall.

4. The cabinet of Claim 1, further comprising a third wall connected to said floor and said roof, said third wall comprising a plurality of openings adapted to allow external air to flow into said air-to-air heat exchanger.

5. The cabinet of Claim 4, wherein said third wall and said second wall are on opposite sides of said cabinet.

6. The cabinet of Claim 1, wherein said first and said second wall are on opposite sides of said cabinet.

7. The cabinet of Claim 6, wherein said first wall further comprises a plurality of openings adapted to allow external air to flow into said air-to-air heat exchanger.

8. The cabinet of Claim 2, wherein said inner structure of said first wall and said air-to-air heat exchanger further define, at least partially, at least two other channels for transporting, at least indirectly, internal air between first and second portions of said air-to-air heat exchanger and said at least one other fan.

9. The cabinet of Claim 1, further comprising at least one other fan located in an interior portion of said cabinet and adapted to pass internal air over said at least one electrical device.

10. The cabinet of Claim 3, wherein said roof further comprises at least four fans for circulating external and internal air through said at least one channel in said second wall and said at least one other channel in said first wall.

11. The cabinet of Claim 10, wherein said inner and outer roof structures further define, at least partially, at least four channels located therebetween, wherein each one of said at least four channels are connected to corresponding ones of said at least four fans.

12. The cabinet of Claim 2, wherein said roof further comprises a covering structure, said at least one fan being located between said outer roof structure and said covering structure.

13. A cabinet for housing at least one electrical device, comprising:
a floor;
a first wall connected to said floor, said first wall comprising:
an inner wall structure;
an outer wall structure; and
at least one rib located therebetween, said inner wall, outer wall and at least one rib defining a first and second channel in said first wall;
a first heat exchanger located in said first channel in said first wall;
a second heat exchanger located in said second channel in said first wall;
a second wall connected to said floor, said second wall comprising an inner wall structure and an outer wall structure defining, at least partially, at least one channel in said second wall; and
a roof connected to at least said first and second walls, said roof comprising:
at least one fan for circulating a thermal substance through said first and second heat exchangers and said at least one channel in said second wall; and
at least one other fan for circulating internal air through said first and second heat exchangers.

14. The cabinet of Claim 13, wherein said first wall further comprises:
a sub-inner structure; and
at least one other rib located between said inner structure and said sub-inner structure, thereby defining a third and fourth channel in said first wall, said third and fourth channel adapted to transport internal air between said first and second heat exchangers and said at least one other fan, respectively

15. The cabinet of Claim 13, wherein said second wall further comprises at least one rib located between said inner and outer structures and defining a first and second channel in said second wall, said first and second channels being connected to said first and second heat exchangers, respectively.

16. The cabinet of Claim 13, wherein said roof further comprises:
an inner roof structure;
an outer roof structure; and
at least one rib located therebetween, said inner roof structure, outer roof structure, and at least one rib defining at least two channels in said roof, a first one of said two channels in said roof being connected to said at least one fan and a second one of said two channels in said roof being connected to said at least one other fan.

17. The cabinet of Claim 13, wherein said first and second heat exchangers are air-to-air heat exchangers.

18. The cabinet of Claim 17, wherein said thermal substance is ambient air.

19. The cabinet of Claim 18, further comprising a third wall connected to said floor and said roof, said third wall comprising at least two sets of vents adapted to pass ambient air into said first and second air-to-air heat exchangers.

20. The cabinet of Claim 13, wherein said thermal substance is a fluid, said fluid being packaged and located outside of said cabinet.

21. The cabinet of Claim 19, wherein said third wall is located opposite said second wall.

22. The cabinet of Claim 16, wherein said roof further comprises a covering structure, said at least one fan and said at least one other fan being located between said outer roof structure and said cover structure.

23. A method of managing temperature in a cabinet, said method comprising the steps of:
passing internal air through an internal-portion of said cabinet;
routing said internal air through a first chamber of a heat exchanger, said heat exchanger being mounted inside a first wall of said cabinet;
using at least one fan to move said internal air out of said first chamber of said heat exchanger and into said interior-portion of said cabinet;
introducing a thermal substance into a second chamber of said heat exchanger; and
routing said thermal substance (i) out of said second chamber of said heat exchanger, (ii) through at least one channel in a second wall of said cabinet, and (iii) out of said cabinet.

24. The method of Claim 23, wherein said step of using at least one fan further comprises using said at least one fan to move said internal air (i) out of said first chamber of said heat exchanger, (ii) through at least one channel in said first wall, and (iii) into said interior portion of said cabinet.

25. The method of Claim 23, wherein said step of introducing a thermal substance into a second chamber of said heat exchanger further comprises introducing external air into said second chamber of said heat exchanger in order to cool said internal air.

26. The method of Claim 23, wherein said step of introducing a thermal substance into a second chamber of said heat exchanger further comprise introducing a fluid into said second chamber of said heat exchanger in order to manage the temperature of said internal air.

27. The method of Claim 23, wherein said step of routing said thermal substance further comprises using at least one other fan to route said thermal substance (i) out of said second chamber of said heat exchanger, (ii) through at least one channel in a second wall of said cabinet, and (iii) and out of said cabinet.

28. The method of Claim 23, wherein said step of using at least one fan to move said internal air is achieved by using said at least one fan to create a vacuum in at least said first chamber of said heat exchanger.

29. The method of Claim 24, wherein said step of using at least one fan to move said internal air is achieved by positioning said at least one fan (i) in the route of said internal air and (ii) between said at least one channel in said first wall and said interior portion of said cabinet, thereby creating a vacuum in at least said at least one channel in said first wall.

30. The method of Claim 27, wherein said step of routing said thermal substance is achieved by positioning said at least one other fan (i) in the route of said thermal substance and (ii) between said at least one channel in said second wall of said cabinet and the outside of said cabinet, thereby creating a vacuum in at least said at least one channel in said second wall.
